# EUROPEAN PATENT APPLICATION

(11) **EP 4 326 013 A1**
(43) Date of publication of application: **21.02.2024**
(21) Application number: 22922338.3
(22) Date of filing: 18.11.2022
(51) Int. Cl.: H05K 1/03, C09H 5/00

(54) **DEGRADABLE SUBSTRATE FOR ELECTRONIC DEVICE, DEGRADABLE SUBSTRATE ASSEMBLY FOR ELECTRONIC DEVICE, AND METHOD FOR MANUFACTURING DEGRADABLE SUBSTRATE FOR ELECTRONIC DEVICE**

(30) Priority: 18.01.2022 KR 20220007309
(71) Applicant: Korea University Research and Business Foundation, Seoul 02841 (KR)
(72) Inventor: HWANG, Suk Won, Seoul 06003 (KR); SHIN, Jeong Woong, Seoul 05385 (KR)
(74) Representative: Prüfer & Partner mbB Patentanwälte · Rechtsanwälte
(86) International application number: PCT/KR2022/018364
(87) International publication number: WO 2023/140480

(57) **Abstract**

The present invention relates to a degradable substrate for an electronic device, a degradable substrate assembly for an electronic device, and a method for manufacturing a degradable substrate for an electronic device. The degradable substrate for an electronic device according to an embodiment of the present invention comprises: a substrate base material which is a polymer material; and a degradable foam-generating material which is in the form of particles uniformly mixed with the substrate base material and generates foam by reacting with water.

## Description

### [Technical Field]

The present invention relates to a degradable substrate for an electronic device, a degradable substrate assembly for an electronic device, and a method for manufacturing a degradable substrate for an electronic device, and more specifically, to a degradable substrate for an electronic device, which can be rapidly degraded by reacting with water and is harmless to a human body and environment, a degradable substrate assembly for an electronic device, and a method for manufacturing a degradable substrate for an electronic device.

### [Background Art]

One of the important indicators of devices in the existing semiconductor and electronic engineering is reliability of stable operation without performance deterioration during long-term use. However, as the new semiconductor technology that has been proposed recently, a technology called transient electronics or destructive and degradable electronics, which can be used according to a user's purpose with a specific controlled physical lifespan rather than a long period of time, is emerging.

This technology consists of materials capable of activating a destruction function by water, heat, microorganisms, and other factors, and has a function that is used in industry or daily life while maintaining the performance of the fabricated device to a level of a commercial device, so that when a situation in which the electronic device is unnecessary and needs to be removed occurs, it can be disappeared through physically and chemically complete degradation.

There are two main methods to adjust the destructive and degradable characteristics: first, a method for controlling the lifespan period by adjusting the density, crystallinity, and thickness of a material constituting an insulation layer (passivation) and a protective layer (encapsulation); and second, a method for performing degradation by being triggered due to external stimuli.

As the existing technologies capable of performing active degradation due to external stimuli, technologies leading to ignition, corrosive compounds, mechanical destruction by heat, light, and electric stimuli have been suggested. However, the technologies have disadvantages in that there are many materials that are toxic to a human body or environment, it is difficult to store because it is unstable due to high chemical reactivity, it is difficult to synthesize a reactive compound in response to the external stimuli, or a degradation rate is not fast.

### [Disclosure]

### [Technical Problem]

The present invention is to provide a degradable substrate for an electronic device which can be rapidly degraded by reacting with water, a degradable substrate assembly for an electronic device, and a method for manufacturing a degradable substrate for an electronic device.

In addition, the present invention is to provide a degradable substrate for an electronic device which is harmless to a human body and environment, a degradable substrate assembly for an electronic device, and a method for manufacturing a degradable substrate for an electronic device.

### [Technical Solution]

According to one aspect of the present invention, there may be provided a degradable substrate for an electronic device comprising: a substrate base material which is a polymer material; and a degradable foam-generating material which is provided in a form of particles while being uniformly mixed with the substrate base material and generates foam by reacting with water.

In addition, the substrate base material may be one of gelatin, polyvinylpyrrolidone (PVP), polyhydroxyalkanoate (PHA), polyhydroxybutyrate (PHB), polyvinyl alcohol (PVA), collagen, cellulose, polyactic acid (PLA), poly(D,L-lactideco-glycolic acid) (PLGA), and polycarprolactone (PCL), or a mixture thereof.

In addition, the degradable foam-generating material may be formed of organic acid and hydrogen carbonate.

In addition, the organic acid may be one of citric acid, malic acid, succinic acid, malonic acid, tartaric acid, and acetic acid, or a mixture thereof.

In addition, the hydrogen carbonate may be one of sodium hydrogen carbonate, and potassium hydrogen carbonate, or a mixture thereof.

In addition, the degradable foam-generating material may be provided such that a molar ratio of the organic acid and the hydrogen carbonate is in a range of 1:1 to 1:3.

In addition, the substrate base material and the degradable foam-generating material may have a weight ratio in a range of 4:1 to 1:2.

In addition, the degradable substrate for an electronic device may further include a plasticizer, and the substrate base material may be gelatin.

According to another aspect of the present invention, there may be provided a degradable substrate assembly comprising: a degradable substrate for an electronic device, which includes a substrate base material which is a polymer material; and a fluid path formation module attached to a bottom surface of the degradable substrate for the electronic device to control a supply state of water, wherein the fluid path formation module may include: a fluid path formation layer formed inside thereof with an inlet-side fluid path and an operation-side fluid path; and a pneumatic valve control layer located below the fluid path formation layer to allow the inlet-side fluid path and the operation-side fluid path to be connected to or separated from each other.

In addition, the flow path formation layer may be formed with an accommodation region in a direction opposite to a region in which the operation-side flow path is adjacent to the inlet-side flow path, and the accommodation region may be open upward so as to make contact with the degradable substrate for the electronic device.

In addition, the accommodation region may be filled with a degradable foam-generating material that generates foam by reacting with water.

In addition, the degradable substrate for an electronic device may further include a degradable foam-generating material which is provided in a form of particles while being uniformly mixed with the substrate base material and generates foam by reacting with water.

In addition, the degradable foam-generating material may be formed of organic acid and hydrogen carbonate.

According to still another aspect of the present invention, there may be provided a method for manufacturing a degradable substrate for an electronic element, comprising: mixing a substrate base material with an organic solvent; mixing a degradable foam-generating material with the organic solvent; and drying a solution in which the substrate base material and the degradable foam-generating material are mixed.

In addition, the substrate base material may be a polymer material.

In addition, the degradable foam-generating material may be formed of organic acid and hydrogen carbonate.

In addition, the degradable foam-generating material may be pulverized, and may be mixed with the organic solvent.

In addition, the degradable foam-generating material may be pulverized through ball-milling.

### [Advantageous Effects]

According to one embodiment of the present invention, it is possible to provide a degradable substrate for an electronic device which can be rapidly degraded while generating foam by reacting with water, a degradable substrate assembly for an electronic device, and a method for manufacturing a degradable substrate for an electronic device.

In addition, according to one embodiment of the present invention, it is possible to provide a degradable substrate for an electronic device which is harmless to a human body and environment due to a degradation reaction through a material derived from nature, a degradable substrate assembly for an electronic device, and a method for manufacturing a degradable substrate for an electronic device.

### [Description of Drawings]

FIG. 1 is a flowchart showing a method for manufacturing a degradable substrate for an electronic device according to one embodiment of the present invention.
FIG. 2 is a flowchart showing a process of preparing an organic solvent.
FIG. 3 is a view showing a process of pulverizing a degradable foam-generating material.
FIG. 4 is a view showing a change in particle size of the degradable foam-generating material according to a progress of the pulverization process.
FIG. 5 is a view showing an average particle size and a standard deviation of the particle size of the degradable foam-generating material according to the progress of the pulverization process.
FIG. 6 is a view showing pH of a solution generated during a degradation reaction according to a molar ratio of organic acid and hydrogen carbonate in the degradable foam-generating material.
FIG. 7 is a view showing a process of degrading the degradable substrate for an electronic device made of gelatin serving as a substrate base material according to one embodiment.
FIG. 8 is a view showing a time required for degradation according to a temperature.
FIG. 9 is a view showing mechanical properties of the degradable substrate for an electronic device, which is manufactured after a plasticizer is further added to a solution in which the substrate base material and the degradable foam-generating material are mixed.
FIG. 10 is a view showing a glass transition temperature and a melting point, which are thermal characteristics of the degradable substrate for an electronic device, according to a content of glycerol which is the plasticizer.
FIG. 11 is a view showing transmittance characteristics of a substrate depending on the presence or absence of the degradable foam-generating material.
FIG. 12 is a view showing a contact angle of a surface of the degradable substrate for an electronic device according to a time of water molecules based on a type of plasticizer.
FIG. 13 is a view showing a degradation reaction of a PLGA-based degradable substrate for an electronic device according to one embodiment.
FIG. 14 is a scanning electron microscope (SEM) photograph showing the surface and an internal structure of the PLGA-based degradable substrate for an electronic device according to one embodiment.
FIG. 15 is a view showing mechanical properties of the degradable substrate for an electronic device according to a mass ratio of the degradable foam-generating material and PLGA in the PLGA-based degradable substrate for an electronic device.
FIG. 16 is a view showing a change in weight of the PLGA-based degradable substrate for an electronic device over time.
FIG. 17 is a view showing a process of degrading an electronic device by using the PLGA-based degradable substrate for an electronic device according to one embodiment of the present invention.
FIG. 18 is a view showing a remotely controllable electronic device manufactured using the degradable substrate for an electronic device according to one embodiment of the present invention.
FIG. 19 is a view of comparative experiment showing a biocompatible/biodegradable process in which the degradable substrate for an electronic device according to one embodiment of the present invention and a substrate contrasted thereto are each inserted into a rat for 4 weeks.
FIG. 20 is a view in which histological analysis is performed by cutting a portion of a biological tissue into which the degradable substrate for an electronic device according to one embodiment of the present invention and the substrate contrasted thereto are inserted.
FIG. 21 is an exploded perspective view of a degradable substrate assembly for an electronic device according to another embodiment.
FIG. 22 is a view showing a fluid path formed inside the degradable substrate assembly for an electronic device.
FIG. 23 is a view showing a state in which an inlet-side fluid path and an operation-side fluid path are connected to each other.
FIG. 24 is a view showing a state in which a degradation reaction is performed after a device is formed on an upper surface of the degradable substrate assembly for an electronic device.

### [Mode for Invention]

Hereinafter, preferred embodiments of the present invention will be described in detail with reference to the accompanying drawings. However, the present invention may be embodied in different forms and should not be construed as limited to the embodiments set forth herein. Rather, the embodiments are provided so that this disclosure will be thorough and complete, and will fully convey the scope of the present invention to those skilled in the art.

In the present specification, it will be understood that when an element is referred to as being "on" another element, it can be formed directly on the other element or intervening elements may be present. In the drawings, the thicknesses of layers and regions are exaggerated for clarity.

In addition, it will be also understood that although the terms first, second, third, etc. may be used herein to describe various elements, these elements should not be limited by these terms. These terms are only used to distinguish one element from another element. Thus, a first element in some embodiments may be termed a second element in other embodiments without departing from the teachings of the present invention. Embodiments explained and illustrated herein include their complementary counterparts. As used herein, the term "and/or" includes any and all combinations of one or more of the associated listed elements.

The singular expression also includes the plural meaning as long as it does not differently mean in the context. In addition, the terms "comprise", "have" etc., of the description are used to indicate that there are features, numbers, steps, elements, or combination thereof, and they should not exclude the possibilities of combination or addition of one or more features, numbers, operations, elements, or a combination thereof. Furthermore, it will be understood that when an element is referred to as being "connected" or "coupled" to another element, it may be directly connected or coupled to the other element or intervening elements may be present.

In addition, when detailed descriptions of related known functions or constitutions are considered to unnecessarily cloud the gist of the present invention in describing the present invention below, the detailed descriptions will not be included.

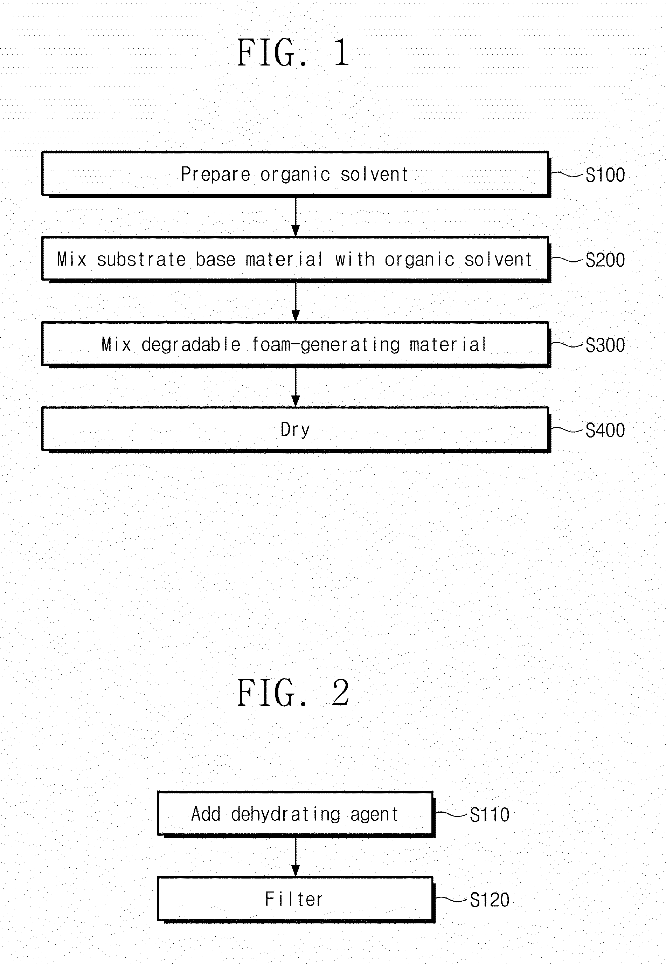

FIG. 1 is a flowchart showing a method for manufacturing a degradable substrate for an electronic device according to one embodiment of the present invention.

Referring to FIG. 1, an organic solvent is prepared (S100). For example, the organic solvent may be hexafluoroisopropanol (HFIP), acetone, butanone, ethyl acetate, methyl acetate, chloroform, or the like.

FIG. 2 is a flowchart showing a process of preparing the organic solvent.

Referring to FIG. 2, the organic solvent may be provided in an anhydrous state. Accordingly, it is possible to prevent interaction in a process of mixing the degradable foam-generating material (degradable bubbling agent (BA)). First, a dehydrating agent is added to the organic solvent (S110). For example, the dehydrating agent may be calcium chloride or the like. The dehydrating agent may be mixed in a volume weight (w/v: weight/volume) of 8% to 12% with respect to the organic solvent.

Thereafter, the dehydrating agent is filtered to extract an anhydrous organic solvent (S120). After the organic solvent and the dehydrating agent are mixed, when the dehydrating agent, which is a solute, sinks, the dehydrating agent is removed from the solution through filtering to extract the anhydrous organic solvent. As the filtering, a reduced pressure filtering method may be used.

Thereafter, a substrate base material is mixed with the organic solvent (S200). The substrate base material is a polymer material. For example, the substrate base material may be one of gelatin, polyvinylpyrrolidone (PVP), polyhydroxyalkanoate (PHA), polyhydroxybutyrate (PHB), polyvinyl alcohol (PVA), collagen, cellulose, polyactic acid (PLA), poly(D,L-lactide-co-glycolic acid) (PLGA), polycarprolactone (PCL), and the like, or a mixture thereof. The substrate base material may be mixed in a volume weight of 3 to 10% with respect to the organic solvent.

Thereafter, the degradable foam-generating material is mixed (S300). The degradable foam-generating material may be agitated through a mixing tool or the like in order to be homogeneously mixed with the organic solvent and the substrate base material. The degradable foam-generating material causes a foam-generating reaction when the degradable substrate for an electronic device meets water, thereby rapidly degrading the degradable substrate for an electronic device due to a loss of the generated foam and degradable foam-generating material. The degradable foam-generating material is formed of organic acid and hydrogen carbonate. Accordingly, when the degradable foam-generating material reacts with water, the degradable foam-generating material is lost by being degraded at a high speed while generating carbon dioxide. In addition, as carbon dioxide is generated in the form of foam on the degradable substrate for an electronic device, the degradation of the degradable substrate for an electronic device is further promoted. The organic acid may be one of citric acid, malic acid, succinic acid, malonic acid, tartaric acid, acetic acid, and the like, or a mixture thereof. The hydrogen carbonate may be one of sodium hydrogen carbonate, potassium hydrogen carbonate, and the like, or a mixture thereof. The degradable substrate for an electronic device may have a weight ratio of the substrate base material and the degradable foam-generating material in a range of 4:1 to 1:2.

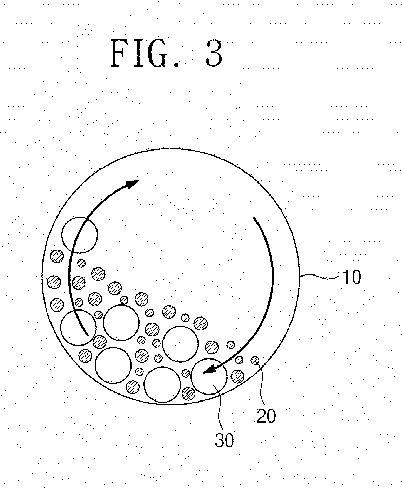

FIG. 3 is a view showing a process of pulverizing a degradable foam-generating material.

Referring to FIG. 3, the degradable foam-generating material may be mixed after the pulverization process such that a particle size thereof is in a preset range in order to adjust reactivity and mechanical properties when the degradable foam-generating material meets water. The degradable foam-generating material may be mixed after being pulverized such that the particle size thereof is an average of 10 µm or less. For example, the degradable foam-generating material may be pulverized through a ball-milling method. The ball-milling is performed by putting a pulverizing ball 3 and a degradable foam-generating material 2 into a drum 1 and rotating the drum 1. In this case, the degradable foam-generating material may be ball-milled in a state in which one of materials corresponding to organic acid or hydrogen carbonate is added. The pulverizing ball 3 may be a ceramic ball. As the drum 1 rotates, the pulverizing ball 3 pulverizes the degradable-bubble generation material 2 while colliding with the degradable foam-generating material 2. When a ceramic ball is used as the pulverizing ball 3, the particle size of the degradable foam-generating material 2 may decrease to 5 µm to 500 nm.

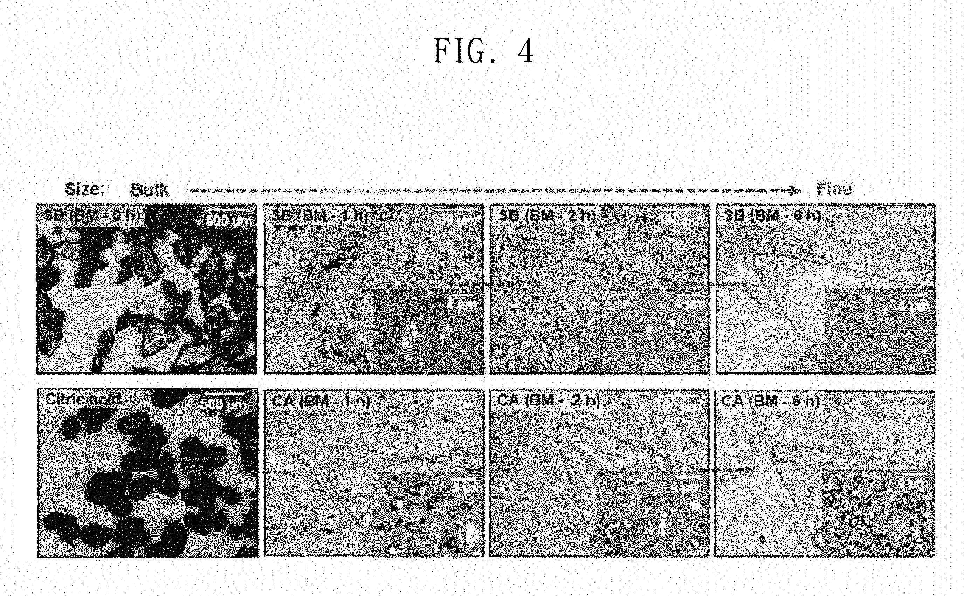

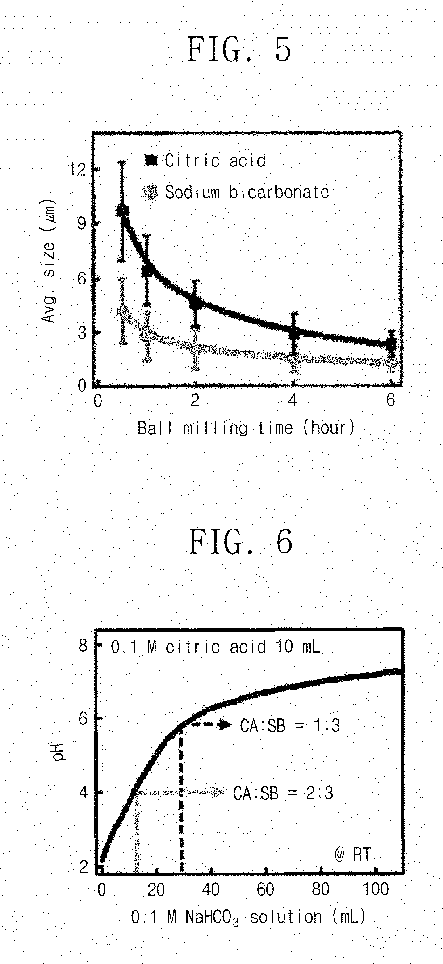

FIG. 4 is a view showing a change in particle size of the degradable foam-generating material according to a progress of the pulverization process. and FIG. 5 is a view showing an average particle size and a standard deviation of the particle size of the degradable foam-generating material according to the progress of the pulverization process.

FIG. 4 is a photograph showing, as a microscopic image, changes in particle size according to a process time by performing the pulverization process on sodium bicarbonate (SB), which is one of hydrogen carbon, and citric acid, which is one of organic acid, using a ball-milling process. At the beginning of the process, the average particle size is around 500 µm, but the particle size rapidly decreases as the pulverization process progresses, and after 6 hours, it can be confirmed that the particle size of sodium hydrogen carbonate decreases to 1 um and the particle size of citric acid decreases to 2 µm.

FIG. 5 shows a change in average size and standard deviation of particles as the pulverization process is performed on each of sodium bicarbonate and citric acid. As the pulverization process is performed using ball-milling, it can be confirmed that the average size of particles decreases and the deviation of the particle size also decrease. That is, it can be seen that uniformity of the particle size increases as the particle size decreases through the pulverization process.

The degradable foam-generating material is homogeneously mixed with the polymer material, which is the substrate base material, in a state where the particle size of the degradable foam-generating material decreases and uniformity of the particle size increases, so that the degradable substrate for an electronic device, which is a composite mixture of the degradable foam-generating material and the substrate base material, may be easily manufactured, and the degradable substrate for an electronic element may be widely used, and when the degradable substrate for an electronic element meets water to cause a degradation reaction, it has an increased degradation rate and homogeneity of a degradation region. Accordingly, it is preferable that the degradable foam-generating material is mixed after the pulverization process is performed so that the average particle size is at least 10 µm or less. More preferably, the degradable foam-generating material is mixed after the pulverization process is performed so that the average particle size is at least 5 um or less.

FIG. 6 is a view showing pH of a solution generated during a degradation reaction according to a molar ratio of organic acid and hydrogen carbonate in the degradable foam-generating material.

FIG. 6 illustrates a case where the organic acid is citric acid (CA) and the hydrogen carbonate is sodium bicarbonate (SB).

Referring to FIG. 6, it can be seen that, pH of the solution in the degradable foam-generating material may be adjusted during degradation according to the ratio of the organic acid and the hydrogen carbonate. Accordingly, when the ratio of the organic acid to the hydrogen carbonate is increased, a low pH condition is formed during the degradation reaction, magnesium (Mg), zinc (Zn), and iron (Fe), which are biodegradable metallic materials, may serve to increase the degradation rate through a metal-acid reaction. In addition, in order for the organic acid and the hydrogen carbonate to interact at an appropriate rate, it is necessary to maintain an appropriate ratio. Thus, a molar ratio of the organic acid and the hydrogen carbonate is preferably in a range of 1:1 to 1:3.

Thereafter, the solution in which the substrate base material and the degradable foam-generating material are mixed is dried to produce a degradable substrate for an electronic device, which includes the substrate base material and the degradable foam-generating material (S400). For example, the solution in which the substrate base material and the degradable foam-generating material are mixed may be poured into a mold having a shape of the degradable substrate for an electronic device, and may be completely dried in a dried condition for 1 to 2 days to produce the degradable substrate for an electronic device. In this case, the degradable substrate for an electronic device is made with a thickness of 100 to 200 µm, and may also be used for an electronic device in a way that the electronic device is injected into a living body. Accordingly, the degradable substrate for an electronic device has a structure in which particles of the degradable foam-generating material are evenly distributed in the substrate base material. In addition, when the degradable substrate for an electronic device reacts with water, it may be rapidly degraded due to foam generated while losing the degradable foam-generating material and interacting between the organic acid and the hydrogen carbonate, which are foam-generating materials.

### Experimental Example 1

Gelatin was used as a substrate base material. A gelatin-based degradable substrate for an electronic device was manufactured by adding 0.6 to 1 g (3 to 5% w/v) of gelatin, which was extracted from a porcine, and 0.3 to 1 g (1.5 to 5% w/v) of glycerol, which is a plasticizer, to 20 mL of HFIP in a glove box to prepare a polymer solution. The degradable foam-generating material was mixed and stirred by adding 0.3 to 1.2 g (1.5 to 6% w/v) of the pulverized organic acid (citric acid) and hydrogen carbonate (sodium hydrogen carbonate) thereto (a molar ratio of organic acid:hydrogen carbonate = 1:1 to 1:3), and a poly(dimethylsiloxane) (PDMS) casting frame was filled with a solution, was dried for 24 hours, and was additionally dried for 24 hours in a dryer, thereby manufacturing a degradable substrate for an electronic device. The thickness of the degradable substrate for an electronic device was set to 50 µm to 200 µm depending on the ratio of the degradable foam-generating material to gelatin. In this case, the degradable substrate for an electronic device may have a weight ratio of gelatin and the degradable foam-generating material in a range of 10:3 to 1:2.

### Experimental Example 2

As another example, PLGA was used as the substrate base material. A PLGA-based degradable substrate for an electronic device was manufactured under the same condition as gelatin, and a polymer solution was formed by dissolving 1 to 2 g (5 to 10% w/v) of PLGA (lactide:glycolide = 50:50, 65:35) in 20 mL of acetone. The degradable foam-generating material was mixed by adding 0.5 to 2 g (2.5 to 10% w/v) of the pulverized organic acid and hydrogen carbonate at a molar ratio (1:1 to 1:3), and the mixture thereof was put into a PDMS casting frame and dried in the same manner as described above, thereby manufacturing a degradable substrate for an electronic device. In this case, the degradable substrate for an electronic device may have a weight ratio of PLGA and the degradable foam-generating material in a range of 4:1 to 1:2.

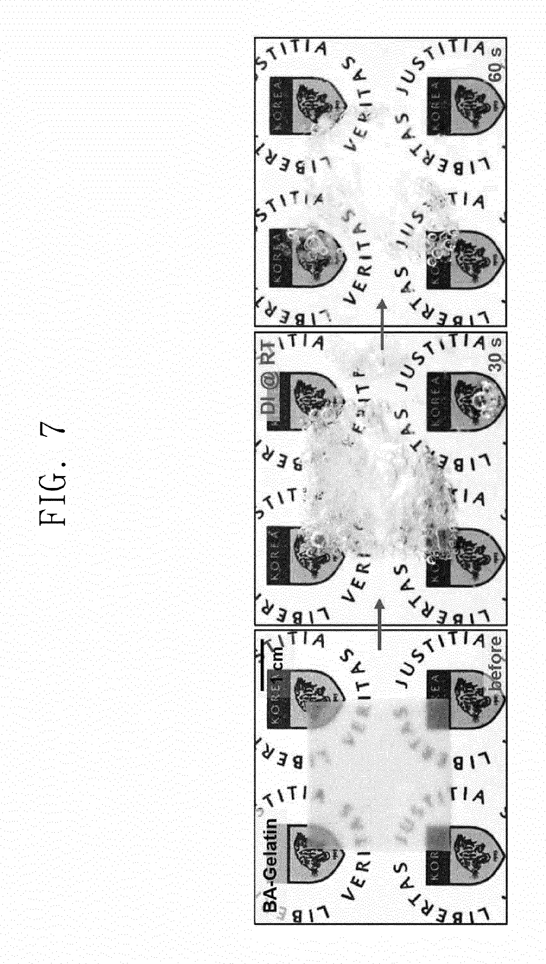

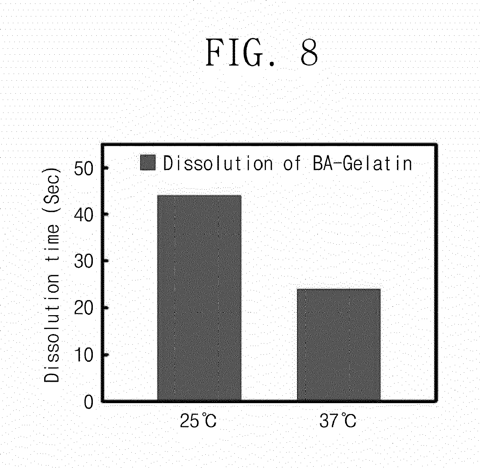

FIG. 7 is a view showing a process of degrading the degradable substrate for an electronic device made of gelatin serving as a substrate base material according to one embodiment, and FIG. 8 Is a view showing a time required for degradation according to a temperature.

Referring to FIGS. 7 and 8, it can be confirmed that the degradation reaction occurs while rapidly generating foam by reacting with water at room temperature (25°C), and the degradable substrate for an electronic device is destroyed within 60 seconds.

In addition, it can be confirmed that the degradation reaction rate is increased under a temperature condition (37°C) corresponding to a body temperature, so that after the reaction with water, the destruction is rapidly performed within 30 seconds. That is, it can be confirmed that the degradation reaction rate is proportional to a temperature of the surrounding environment.

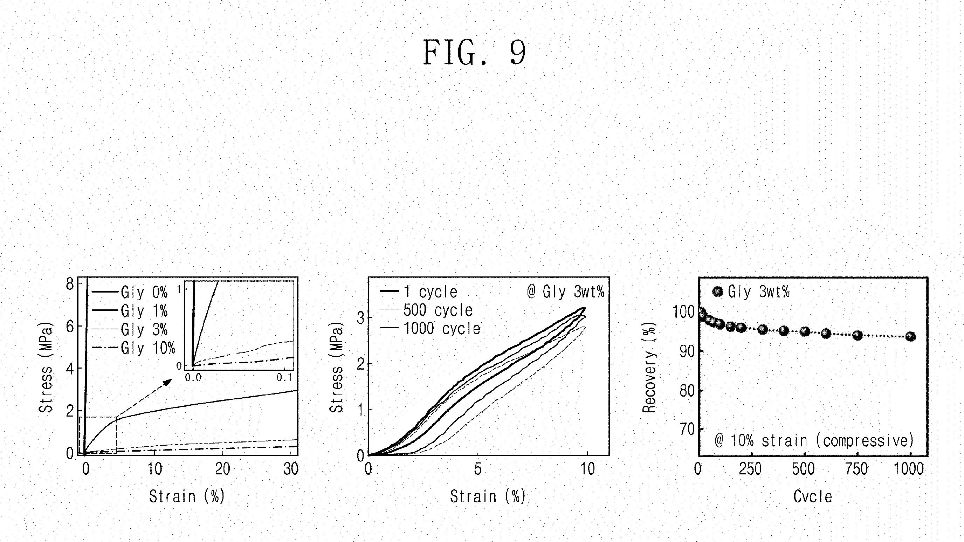

FIG. 9 is a view showing mechanical properties of the degradable substrate for an electronic device, which is manufactured after a plasticizer is further added to a solution in which the substrate base material and the degradable foam-generating material are mixed. The plasticizer may be glycerol, sorbitol, or the like.

In the present example, gelatin was used as a polymer material which is the substrate base material, and glycerol was used as a plasticizer.

Referring to FIG. 9, the degradable substrate for an electronic device, which is manufactured by adding the plasticizer, exhibits restorability and durability of 90% or greater for 1000 times through repeated mechanical durability tests in the form of a loading/unloading cycle. That is, the degradable substrate for an electronic device may be manufactured by further adding the plasticizer to a solution in which the substrate base material and the degradable foam-generating material are mixed, and drying the mixture thereof, thereby reducing a brittle characteristic and obtaining ductility and flexibility, and thus the degradable substrate for an electronic device may be used as a wearable form.

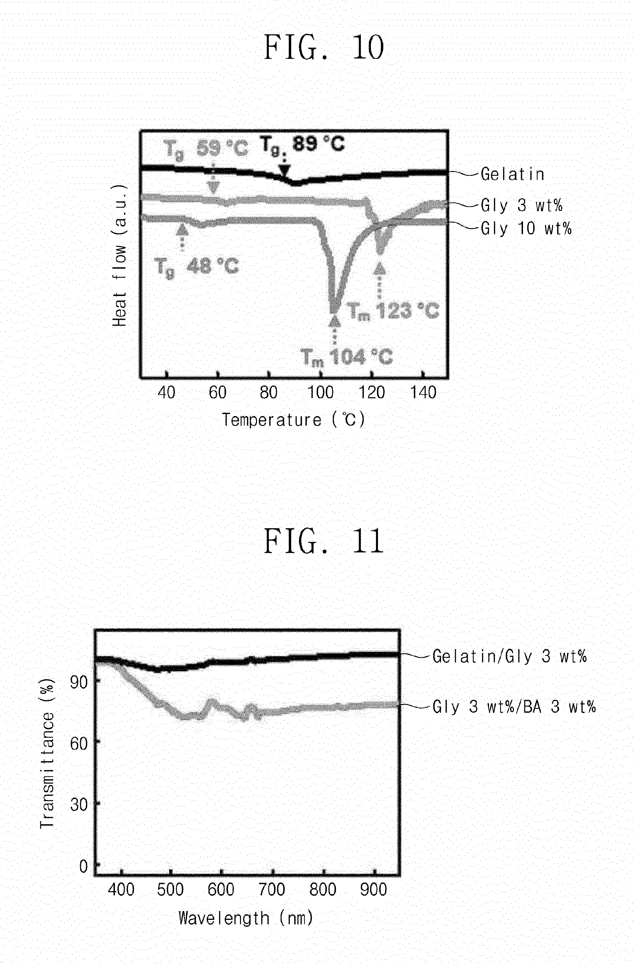

FIG. 10 is a view showing a glass transition temperature and a melting point, which are thermal characteristics of the degradable substrate for an electronic device, according to a content of glycerol which is the plasticizer.

Referring to FIG. 10, as an amount of glycerol increases, it can be confirmed that the glass transition temperature and the melting point move to a low temperature. Accordingly, the glass transition temperature and the melting point of the degradable substrate for an electronic device may be adjusted according to the purpose of use by adjusting the amount of the plasticizer to be added.

FIG. 11 is a view showing transmittance characteristics of a substrate depending on the presence or absence of the degradable foam-generating material.

Gelatin was used as the substrate base material. Glycerol was used as the plasticizer. It can be confirmed that the degradable substrate for an electronic device, which is manufactured by adding the degradable foam-generating material, maintains a transmittance of 70% or greater compared to a substrate, which is manufactured without the degradable foam-generating material. That is, even if the degradable foam-generating material is added, the transmittance of a predetermined range or greater is maintained, so that the degradable substrate for an electronic device may be manufactured with a transmittance of a predetermined range or greater.

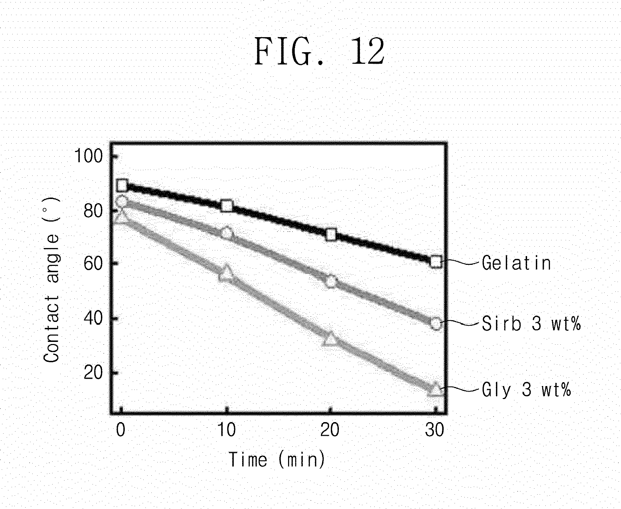

FIG. 12 is a view showing a contact angle of a surface of the degradable substrate for an electronic device according to a time of water molecules based on a type of plasticizer.

Gelatin was used as the polymer material which is the substrate base material. Referring to FIG. 12, it can be seen that the contact angle of the surface of the degradable substrate for an electronic device according to the time of water molecules varies based on a type of plasticizer. In this case, the contact angle is inversely proportional to hygroscopicity. Thus, it can be seen that the hygroscopicity of the degradable substrate for an electronic device may be adjusted through a selection of the type of plasticizer, and accordingly, the degradation rate may be adjusted. Further, in order to increase the degradation rate of the degradable substrate for an electronic device, it is preferable that the plasticizer is glycerol having higher hygroscopicity than sorbitol.

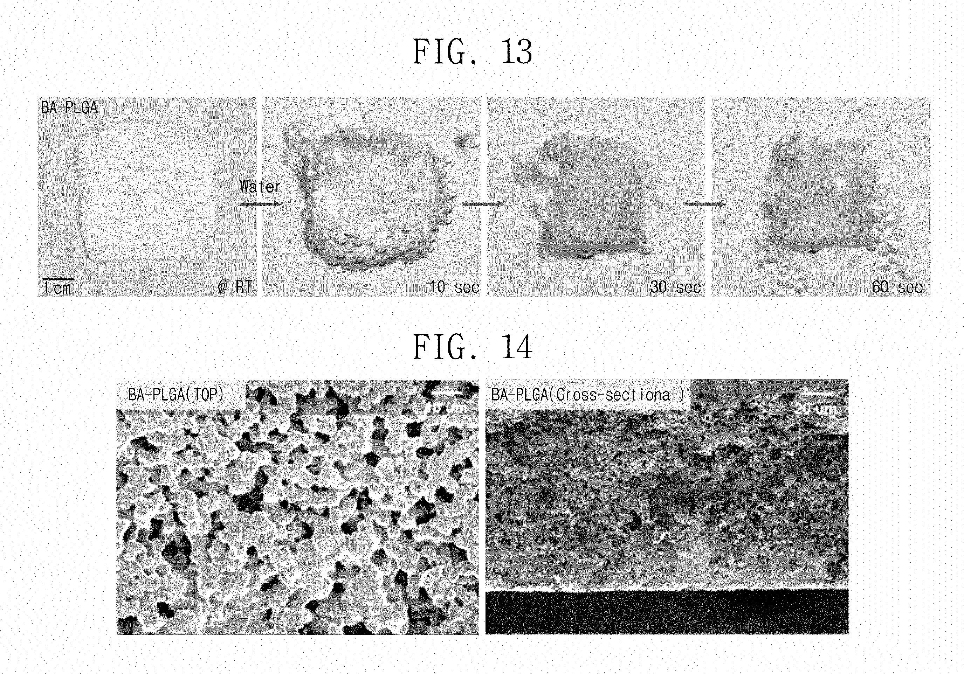

FIG. 13 is a view showing a degradation reaction of a PLGA-based degradable substrate for an electronic device according to one embodiment.

PLGA was used as the substrate base material, and sodium bicarbonate and citric acid were used as degradable foam-generating materials. The degradable substrate for an electronic device may have a thickness of 50 um to 300 µm.

After the reaction with water, it can be confirmed that the PLGA-based degradable substrate for an electronic device is destroyed within 60 seconds. That is, even when the degradable substrate for an electronic device is based on PLGA, which is a polymer having a degradation rate that is relatively slower than a degradation rate of gelatin, it is easily degraded after reacting with water.

FIG. 14 is a scanning electron microscope (SEM) photograph showing the surface and an internal structure of the PLGA-based degradable substrate for an electronic device according to one embodiment.

Referring to FIG. 14, a rapid destruction phenomenon is explained that the degradable substrate for an electronic device, in which the substrate base material is PLGA, has a microporous structure, so that water rapidly penetrates inside thereof through the microporous structure, resulting in rapid reaction by water.

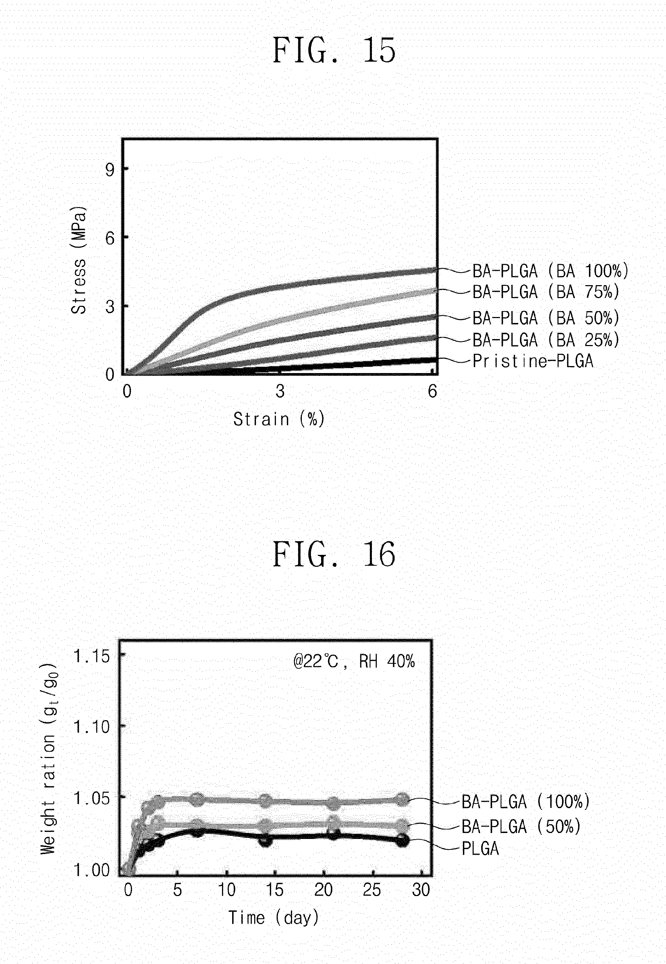

FIG. 15 is a view showing mechanical properties of the degradable substrate for an electronic device according to a mass ratio of the degradable bubble-generating material to PLGA in the PLGA-based degradable substrate for an electronic device.

Referring to FIG. 15, it can be confirmed that the ductility of the degradable substrate for an electronic device is lowered as a content of the degradable foam-generating material with respect to PLGA is increased. Therefore, the ductility of the degradable substrate for an electronic device may be adjusted by adjusting a mass ratio of the degradable foam-generating material for PLGA.

FIG. 16 is a view showing a change in weight of the PLGA-based degradable substrate for an electronic device over time.

It can be seen that in cases where the mass ratios of the degradable foam-generating material to PLGA are 50% and 100%, respectively there is no significant change in mass over 30 days based on an exposure to an environment at a temperature of 22°C and relative humidity of 40%. Therefore, it can be confirmed that the PLGA-based degradable substrate for an electronic device may be stably stored for a long period of time.

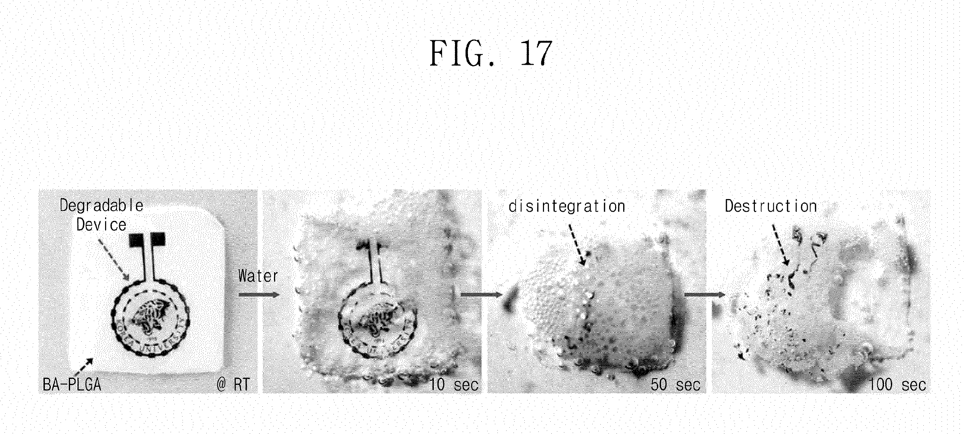

FIG. 17 is a view showing a process of degrading an electronic device by using the PLGA-based degradable substrate for an electronic device according to one embodiment of the present invention.

A device region formed on an upper surface of the substrate was manufactured by selecting magnesium from degradable electrode materials (magnesium (Mg), iron (Fe), zinc (Zn), molybdenum (Mo), and tungsten (W)). The device was manufactured by forming films of poly(methyl methacrylate) (PMMA) and polyimide (PI) to thicknesses of 50 to 500 nm and 1 to 10 µm, respectively. After magnesium having a thickness of 100 to 500 nm, which was deposited through a sputter, an e-beam evaporator, and thermal evaporators, was patterned by photolithography, which is a semiconductor process, an insulating layer (passivation) protecting the metal layer with a thickness of 50 to 300 nm was deposited through the sputter and the electron beam evaporator, and was patterned by using magnesium oxide (MgO) and silicon oxide (SiO2). After a thin PI layer was coated onto the insulating layer (passivation), it was patterned and etched according to design through photolithography and a reactive ion etcher (RIE). Thereafter, the entire silicon wafer substrate was immersed in an acetone solution to remove a sacrificial layer, i.e., a PMMA layer. In this case, a PI/metal/insulating layer/PI layer on PMMA may be separated from the silicon wafer substrate, and after the PI/metal/insulating layer/PI layer was separated using a PDMS stamp, a high-temperature peeling tape, a water peeling tape, or the like, the remaining PI film layer was etched through the RIE and transferred to the degradable substrate for an electronic device, thereby completing an electronic device using the degradable substrate for an electronic device. Accordingly, it can be confirmed that the electronic device using the degradable substrate for an electronic device reacts with water at room temperature and is completely degraded within 100 seconds. In addition, the electronic device manufactured using the degradable substrate for an electronic device is deteriorated in performance such that it is almost impossible to perform a function after approximately 60 seconds, and thus it shows a performance degradation rate of more than 55 times faster compared to a substrate manufactured using the substrate base material without the degradable foam-generating material.

That is, even in the case of the electronic device manufactured using a degradable substrate for an electronic element, it can be confirmed that the degradation is completed without a significant difference compared to the case of the degradable substrate for an electronic element that may be degraded alone.

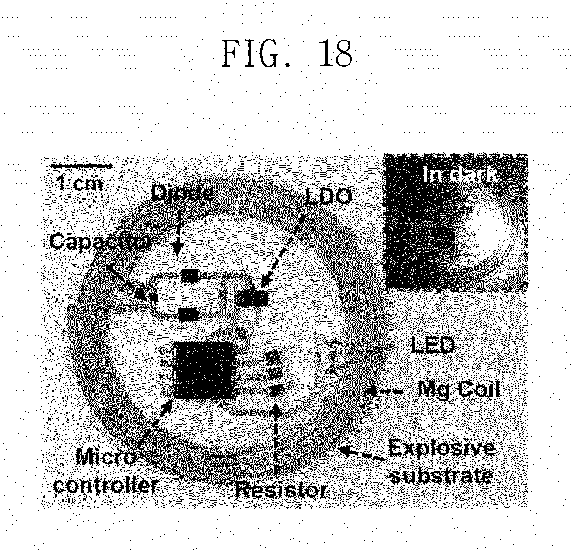

FIG. 18 is a view illustrating a remotely controllable electronic device manufactured using the degradable substrate for an electronic device according to one embodiment of the present invention.

Referring to FIG. 18, a wearable-type chip may be configured by introducing commercial devices into the degradable substrate for an electronic device. Such an electronic device may be operated by remotely receiving power using a frequency band (13.56 MHz) in which near-fieldcommunication (NFC) is possible. As the substrate base material of the degradable substrate for an electronic device, gelatin was used. The electronic device is implemented to be remotely operated by including a microcontroller, a linear regulator (low drop out (LDO)), a diode, a capacitor, a micro LED, a coil patterned by laser cutting (Mg, 5 to 50 µm thick), a connection line (Mg interconnect, 1 to 10 um thick), and the like. It can be confirmed that the electronic device implemented in this way also reacts with water to be selfdestructed within 300 seconds.

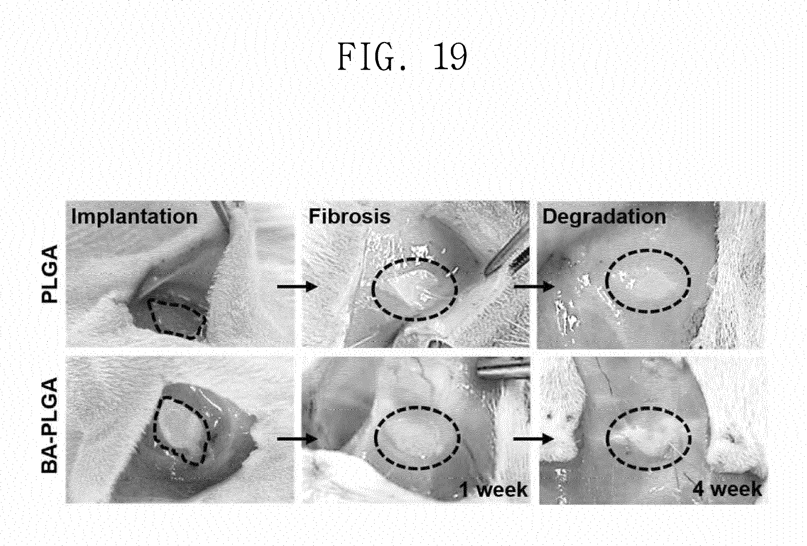

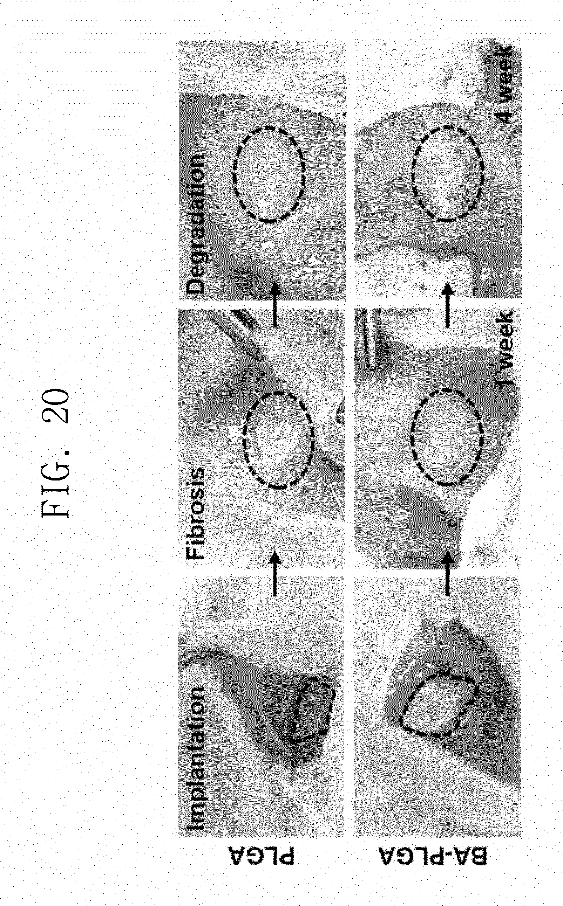

FIG. 19 is a view of comparative experiment showing a biocompatible/biodegradable process in which the degradable substrate for an electronic device according to one embodiment of the present invention and a substrate contrasted thereto are each inserted into a rat for 4 weeks, and FIG. 20 is a view in which histological analysis is performed by cutting a portion of a biological tissue into which the degradable substrate for an electronic device according to one embodiment of the present invention and the substrate contrasted thereto are inserted.

As for the degradable substrate for the electronic device, PLGA was used as a substrate base material, and as for the substrate contrasted thereto, a substrate manufactured only using PLGA without the degradable foam-generating material was used. In this regard, it can be confirmed that the degradable substrate for an electronic device according to one embodiment of the present invention is stably degraded in vivo, similar to the case in which only PLGA is present. In addition, even in the biological tissue in which the degradation reaction occurs, there is no significant difference from the case in which only PLGA is present, and it can be confirmed that even if the degradable foam-generating material is added, the inhibition of biocompatibility does not occur. That is, since the degradable foam-generating material is a material derived from nature, the degradable substrate for an electronic device is harmless to a human body or environment in an in vivo injection process and a degradation process.

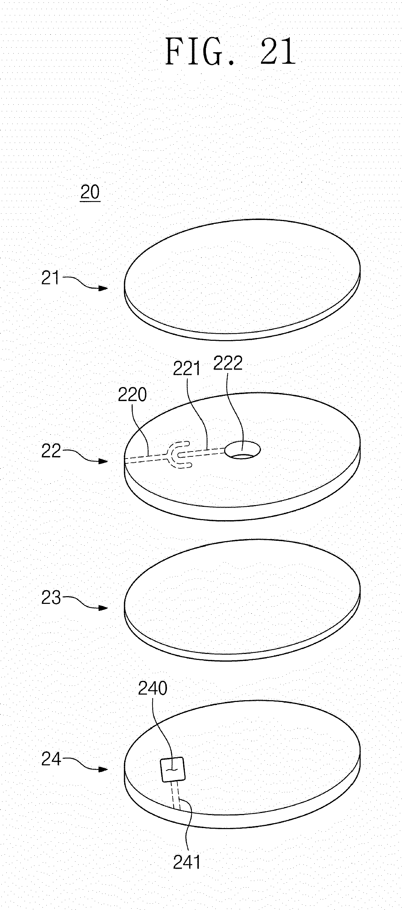

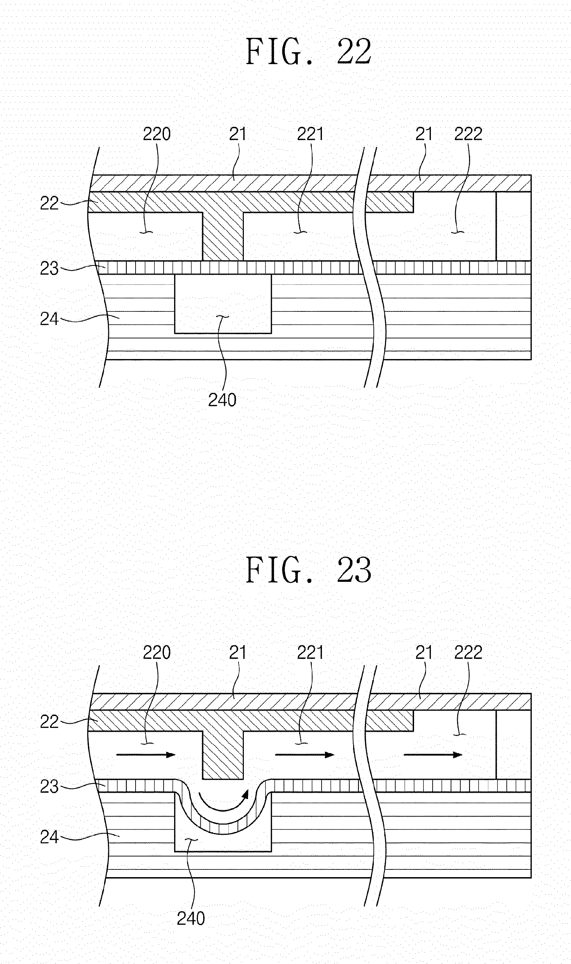

FIG. 21 is an exploded perspective view of a degradable substrate assembly for an electronic device according to another embodiment, FIG. 22 is a view showing a fluid path formed inside the degradable substrate assembly for an electronic device, and FIG. 23 is a view showing a state in which an inlet-side fluid path and an operation-side fluid path are connected to each other.

Referring to FIGS. 21 to 23, a degradable substrate assembly 20 for an electronic device includes a degradable substrate 21 for an electronic device and fluid path formation modules 22, 23, and 24.

The degradable substrate 21 for an electronic device may include a substrate base material and a degradable foam-generating material as in the above-described embodiment. In addition, the degradable substrate for an electronic device may include the substrate base material without the degradable foam-generating material.

The fluid path formation modules 22, 23, and 24 include a fluid path formation layer 22 and a pneumatic valve control layer 24. The fluid path formation modules 22, 23, and 24 are attached to a bottom surface of the degradable substrate for an electronic device. The fluid path formation modules 22, 23, and 24 control a supply state of water supplied to the degradable substrate 21 for an electronic device. An inlet-side fluid path 220 and an operation-side fluid path 221 are formed inside the fluid path formation layer 22. The inlet-side fluid path 220 and the operation-side fluid path 221 are disconnected while being space apart at a preset distance. A region, in which the inlet-side fluid path 220 and the operation-side fluid path 221 are adjacent to each other while being disconnected from each other, is open downward.

An accommodation region 222 is formed at a location opposite to the region of the operation-side fluid path 221 adjacent to the inlet-side fluid path 220. The accommodation region 222 may be open upward so as to make contact with the degradable substrate 21 for an electronic device. The accommodation region 222 may be filled with the degradable foam-generating material. As in the above-described embodiment, the degradable foam-generating material is formed of organic acid and hydrogen carbonate, and a mixture thereof is filled in a paste state.

The pneumatic valve control layer 24 is located below the fluid path formation layer 22. The pneumatic valve control layer 24 allows the inlet-side fluid path 220 and the operation-side fluid path 221 to be connected to or separated from each other. An upper portion of the pneumatic valve control layer 24 is formed with a control space 240 located below the region in which the inlet-side fluid path 220 and the operation-side fluid path 221 are adjacent to each other while being disconnected from each other and which is open upward. The pneumatic valve control layer 24 is formed with a control fluid path 241 connected to the control space 240.

A membrane 23 is located between the fluid path formation layer 22 and the pneumatic valve control layer 24 in the form of covering the open upper part of the control space 240. The membrane 23 has preset elasticity so as to make close contact with a bottom surface of the region in which the inlet-side fluid path 220 and the operation-side fluid path 221 are adjacent to each other. Accordingly, even in a state in which water is supplied to the inlet-side fluid path 220, the inlet-side fluid path 220 and the operation-side fluid path 221 are maintained in the disconnected state through the membrane 23. When the control space 240 is exhausted and depressurized through the control fluid path 241, the membrane 23 moves toward the control space 240, so that the inlet-side fluid path 220 and the operation-side fluid path 221 are connected through a space formed on the membrane 23. Accordingly, water supplied through the inlet-side fluid path 220 is supplied to the degradable substrate for an electronic device through the accommodation region 222 to degrade the degradable substrate for an electronic device. In addition, even when the degradable substrate for an electronic device is provided without the degradable foam-generating material, the accommodation region 222 is instead filled with the degradable foam-generating material, so that the degradation of the degradable substrate for an electronic device may be promoted due to foam generated in the accommodation region 222.

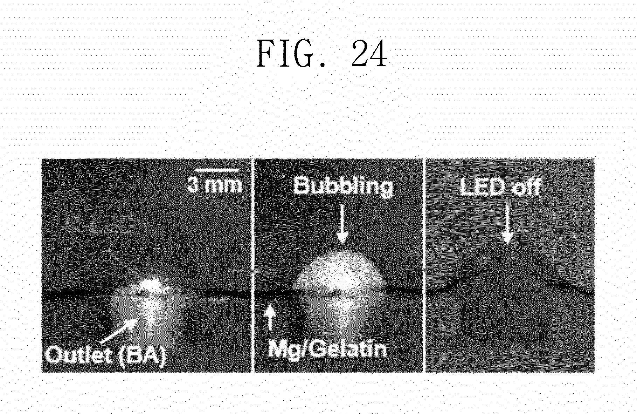

FIG. 24 is a view showing a state in which a degradation reaction is performed after a device is formed on an upper surface of the degradable substrate assembly for an electronic device.

As an example for the state, a frame for the fluid path formation modules 22, 23, and 24 was manufactured using 3D printing. Thereafter, Sylgard A and B were mixed at a ratio of 10:1, and the frame was filled with polydimethylsiloxane (PDMS) to cure the same, thereby manufacturing the fluid path formation layer 22 and the pneumatic valve control layer 24.

As for the device on the upper surface of the degradable substrate for an electronic device, an electronic layer (RF) that is operated remotely may be manufactured by using a micro LED, a diode, a capacitor, an Mg coil (10 to 50 um thick), and an Mg connection line (1 to 5 µm thick). The accommodation region 222 was filled with a paste of a mixture of hydrogen carbonate and organic acid, which are degradable foam-generating materials. As a main part of the device to be destroyed, an LED was placed above the accommodation region 222. Accordingly, it can be confirmed that the device located above the accommodation region can be rapidly destroyed to stop the operation.

While the present invention has been described in connection with the embodiments, it is not to be limited thereto but will be defined by the appended claims. In addition, it is to be understood that those skilled in the art can substitute, change or modify the embodiments in various forms without departing from the scope and spirit of the present invention.

## Claims

1. A degradable substrate for an electronic device, the degradable substrate comprising:
a substrate base material which is a polymer material; and
a degradable foam-generating material which is provided in a form of particles while being uniformly mixed with the substrate base material and generates foam by reacting with water.

2. The degradable substrate of claim 1, wherein the substrate base material is one of gelatin, polyvinylpyrrolidone (PVP), polyhydroxyalkanoate (PHA), polyhydroxybutyrate (PHB), polyvinyl alcohol (PVA), collagen, cellulose, polyactic acid (PLA), poly(D,L-lactide-co-glycolic acid) (PLGA), and polycarprolactone (PCL), or a mixture thereof.

3. The degradable substrate of claim 1, wherein the degradable foam-generating material is formed of organic acid and hydrogen carbonate.

4. The degradable substrate of claim 3, wherein the organic acid is one of citric acid, malic acid, succinic acid, malonic acid, tartaric acid, and acetic acid, or a mixture thereof.

5. The degradable substrate of claim 3, wherein the hydrogen carbonate is one of sodium hydrogen carbonate and potassium hydrogen carbonate, or a mixture thereof.

6. The degradable substrate of claim 3, wherein the degradable foam-generating material has a molar ratio of the organic acid and the hydrogen carbonate in a range of 1:1 to 1:3.

7. The degradable substrate of claim 1, wherein the substrate base material and the degradable foam-generating material have a weight ratio in a range of 4:1 to 1:2.

8. The degradable substrate of claim 1, further comprising a plasticizer, wherein the substrate base material is gelatin.

9. A degradable substrate assembly for an electronic device, the degradable substrate assembly comprising:
a degradable substrate for the electronic device, which includes a substrate base material which is a polymer material; and
a fluid path formation module attached to a bottom surface of the degradable substrate for the electronic device to control a supply state of water,
wherein the fluid path formation module includes:
a fluid path formation layer formed inside thereof with an inlet-side fluid path and an operation-side fluid path; and
a pneumatic valve control layer located below the fluid path formation layer to allow the inlet-side fluid path and the operation-side fluid path to be connected to or separated from each other.

10. The degradable substrate assembly of claim 9, wherein the fluid path formation layer is formed with an accommodation region at a location opposite to a region of the operation-side fluid path adjacent to the inlet-side fluid path, and the accommodation region is open upward so as to make contact with the degradable substrate for the electronic device.

11. The degradable substrate assembly of claim 10, wherein the accommodation region is filled with a degradable foam-generating material that generates foam by reacting with water.

12. The degradable substrate assembly of claim 10, wherein the degradable substrate for the electronic device further includes a degradable foam-generating material which is provided in a form of particles while being uniformly mixed with the substrate base material and generates foam by reacting with water.

13. The degradable substrate assembly of claim 11 or 12, wherein the degradable foam-generating material is formed of organic acid and hydrogen carbonate.

14. A method for manufacturing a degradable substrate for an electronic element, the method comprising:
mixing a substrate base material with an organic solvent;
mixing a degradable foam-generating material with the organic solvent; and
drying a solution in which the substrate base material and the degradable foam-generating material are mixed.

15. The method of claim 14, wherein the substrate base material is a polymer material.

16. The method of claim 14, wherein the degradable foam-generating material is formed of organic acid and hydrogen carbonate.

17. The method of claim 16, wherein the degradable foam-generating material is pulverized, and is mixed with the organic solvent.

18. The method of claim 17, wherein the degradable foam-generating material is pulverized through ball-milling.
